# EUROPEAN PATENT APPLICATION

(11) **EP 1 737 050 A1**
(43) Date of publication of application: **27.12.2006**
(21) Application number: 05727174.4
(22) Date of filing: 23.03.2005
(51) Int. Cl.: H01L 33/00

(54) **LIGHT-EMITTING DEVICE AND ILLUMINATING DEVICE**

(30) Priority: 24.03.2004 JP 2004086667; 27.08.2004 JP 2004248203; 28.01.2005 JP 2005020984
(71) Applicant: TOSHIBA LIGHTING & TECHNOLOGY CORPORATION, Shinagawa-ku, Tokyo 140-8640 (JP)
(72) Inventor: MORIYAMA, T. Toshiba Lighting & Technology Corp., Shinagawa-ku, Tokyo 1408640 (JP); NAKANISHI, A. Toshiba Lighting & Technology Corp., Shinagawa-ku, Tokyo 1408640 (JP); IWAMOTO, M. Toshiba Lighting & Technology Corp., Shinagawa-ku, Tokyo 1408640 (JP); NOGI, S. Toshiba Lighting & Technology Corp., Shinagawa-ku, Tokyo 1408640 (JP); OGAWA, K. Toshiba Lighting & Technology Corp., Shinagawa-ku, Tokyo 1408640 (JP); SHIMIZU, K. Toshiba Lighting & Technology Corp., Shinagawa-ku, Tokyo 1408640 (JP); SAITOU, A. Toshiba Lighting & Technology Corp., Shinagawa-ku, Tokyo 1408640 (JP); KAWASHIMA, S. Toshiba Lighting & Technology Corp., Shinagawa-ku, Tokyo 1408640 (JP); SANPEI, T. Toshiba Lighting & Technology Corp., Shinagawa-ku, Tokyo 1408640 (JP); IZUMI, M. Toshiba Lighting & Technology Corp., Shinagawa-ku, Tokyo 1408640 (JP); TODA, M. Toshiba Lighting & Technology Corp., Shinagawa-ku, Tokyo 1408640 (JP)
(74) Representative: Shindler, Nigel
(86) International application number: PCT/JP2005/005233
(87) International publication number: WO 2005/091387

(57) **Abstract**

Disclosed is a light emitting device 11, with which the luminous efficiency is improved and the color non-uniformity of the emitted light is lessened. Specifically, a light emitting diode element 18 is covered with a diffusing layer 22, with which a diffusing agent is added to a resin. A phosphor layer 23, with which a phosphor is added to a resin, is disposed on top of the diffusing layer 22. The light from the light emitting diode element 18 is diffused by the diffusing layer 22. By exciting the phosphor layer 23 with the light diffused by the diffusing layer 22 and thereby making the phosphor layer 23 emit light, the luminous efficiency is improved and the color non-uniformity is lessened.

## Description

### TECHNICAL FIELD

The present invention relates to a light emitting device having a light emitting element as a light source, and an illuminating device that uses this light emitting device.

### BACKGROUND ART

As a conventional light emitting device, having a light emitting diode element, which is a solid-state light emitting element, as a light emitting element, there is known a surface mounted type light emitting device, with which a light emitting diode element is disposed on a base member and a resin is filled in and hardened so as to cover the light emitting diode element.

As a means of generating white light by this type of light emitting device, there is known an arrangement, with which a blue light, emitted by a blue light emitting diode element, and a yellow light, emitted by a yellow light emitting diode element, are mixed (see, for example, Patent Document 1).

In another known arrangement, a blue light emitting diode element is covered with a resin layer, with which aggregates of a yellow light emitting phosphor of average particle diameter of 3 to 50µm are contained in a resin, and a blue light of the blue light emitting diode element and a yellow light, obtained by excitation of the yellow light emitting phosphor by the blue emitted light, are mixed (see, for example, Patent Document 2).

In regard to states of distribution of phosphor particles in a resin, there is a sedimented form, with which phosphor particles are sedimented at lower portions of a phosphor layer, andadispersedform, with which phosphor particles are dispersed across the entirety of a resin layer.
- Patent Document 1: Japanese Laid-Open Patent Publication No. 2002-43625 (page 3, FIG. 1)
- Patent Document 2: Japanese Laid-Open Patent Publication No. 2001-148516 (page 4, FIG. 1)

### DISCLOSURE OF THE INVENTION

### PROBLEMS TO BE SOLVED BY THE INVENTION

However, with the light emitting device using the blue light emitting diode element and the yellow light emitting diode element, because there is a distance between the blue light emitting diode element and the yellow light emitting diode element, it is difficult to mix the blue light and the yellow light uniformly, the luminous efficiency is low, and the color tends to be different from that of white light. Furthermore, the need for a space for installing at least two light emitting diode elements that respectively emit blue light and yellow light causes an equipment, in which the light emitting device is installed, to become large.

Also, with the light emitting device, in which the blue light emitting diode element is covered with a resin layer containing the yellow light emitting phosphor, when the device is viewed from a direction perpendicular to the outer surface of the resin layer, whereas at a central portion of the resin layer at which the blue light emitting diode element is positioned, the luminance of the blue light is high, the blue light passes through, and the white light appears bluish because the distance between the central portion of the resin layer and the blue light emitting diode element is closer than the distance between a peripheral portion of the resin layer and the blue light emitting diode element, at the peripheral portion of the resin layer, the yellow light is distributed, and there is thus a color non-uniformity.

A comparison of the luminous efficiencies of the sedimented and the dispersed distribution states of the phosphor particles in the resin layer has shown that by using the dispersed type, the luminous efficiency is improved by approximately 20%. Thus, with a white light emitting device, with which improved luminous efficiency is demanded along with color rendering properties, etc., the dispersed type is preferably used.

However, with the dispersed type, when in filling a resin into a base member that has a light emitting diode element disposed thereon, the viscosity of the resin is too high, entrainment of air bubbles, etc., occurs. Although a transparent resin of comparatively low viscosity must thus be used, in a transparent resin of low viscosity, the sedimentation of the phosphor particles occurs rapidly and a dispersed type structure is difficult to realize. Furthermore, when a transparent resin of low viscosity is used, the phosphor particles may sediment inside a dispenser and cause inadvertent effects on the manufacturing efficiency and manufacturing cost of the light emitting device. Although there are methods of filling while stirring inside a dispenser, entrainment of bubbles, non-uniformity of stirring at portions, etc., may occur with such methods.

Meanwhile, the particle diameter of the phosphor particles affects the sedimentation of the phosphor particles in a resin. Although the phosphor particles become less likely to sediment in the transparent resin the smaller the particle diameter of the phosphor particles, the luminous efficiency of the phosphor itself generally decreases as the particle diameter decreases. Thus, even if a dispersed type structure is obtained using phosphor particles of small particle diameter, the lowering of the luminous efficiency of the phosphor itself cancels out the luminous efficiency improvement effect provided by the dispersed type structure. The luminous efficiency of a light emitting device cannot be improved thereby.

Although the Patent Document 1 describes the use of aggregates of phosphor of an average particle diameter of 3 to 50µm for suppressing luminance fluctuations, because with an aggregate, with which phosphor particles are aggregated in a resin, the particle diameter of the phosphor itself is not increased, the luminous efficiency of the phosphor depends on the particle diameter of the phosphor particles before aggregation and the luminous efficiency of the phosphor thus cannot be improved with an aggregate of the phosphor.

The present invention has been made in view of such points, and an object thereof is to provide a light emitting device, with which the luminous efficiency can be improved and the color non-uniformity of the emission color can be lessened, and an illuminating device that uses this light emitting device.

### MEANS FOR SOLVING THE PROBLEMS

A light emitting device according to claim 1 includes: a light emitting element, disposed on a base member; a diffusing layer, covering the light emitting element; and a phosphor layer, disposed on top of the diffusing layer.

By diffusing the light from the light emitting element by means of the diffusing layer that covers the light emitting element and exciting the phosphor layer, disposed at the upper layer of the diffusing layer, by the diffused light to make the phosphor layer emit light, the luminous efficiency is improved and the color non-uniformity of the emission color is lessened.

With the present invention, the light emitting element excites the phosphor by emitted light and thereby makes the phosphor emit visible light. A blue light emitting diode element, an ultraviolet light emitting diode element, etc., can be cited as examples of the light emitting element. However, the light emitting element is not restricted to these, and any one of various light emitting elements can be used according to the application of the light emitting device, the intended emission color, etc., as long as the light emitting element can excite and make the phosphor emit visible light.

The phosphor emits visible light upon being excited by the light emitted from the light emitting element, and a color desired of the light emitting device is obtained by color mixing of the visible light emitted from the phosphor and the light emitted from the light emitting element, by the visible light emitted from the phosphor, or by color mixing of the visible light itself. The type of the phosphor is not restricted in particular and is selected as suitable according to the intended emission color, the light emitted from the light emitting element, etc.

The diffusing layer and the phosphor layer may be arranged by adding a diffusing agent and a phosphor in any one of various transparent resins, such as an epoxy resin or a silicone resin.

Claim 2 provides the light emitting device according to claim 1, in which the diffusing layer has a diffusing agent, and an added amount of the diffusing agent is 3 to 5 mass%.

By making the added amount of the diffusing agent 3 to 5 mass%, the lowering of the luminous efficiency is suppressed and the color non-uniformity is lessened. When the added amount of the diffusing agent is less than 3 mass%, the diffusing effect is lowered and thus the color non-uniformity lessening effect is lowered, while when the added amount of the diffusing agent exceeds 5 mass%, the luminous flux decreases due to increase of the amount of light absorbed by the base member.

Claim 3 provides the light emitting device according to claim 1 or 2, in which a bonding surface of the diffusing layer and the phosphor layer is formed to a concavely curved surface that is recessed toward the light emitting element side.

By the surface of bonding of the diffusing layer and the phosphor layer being a concavely curved surface that is recessed toward the light emitting element side, the bonding area is increased, the strength of bonding of the diffusing layer and the phosphor layer is fortified, and the peeling of the diffusing layer and the phosphor layer is thus suppressed in comparison to the case where the bonding surface is a flat surface.

Claim 4 provides the light emitting device including: a light emitting element, disposed on a base member; and a phosphor layer, having a phosphor that emits visible light upon being excited by light emitted from the light emitting element and includes phosphor particles, which are secondary particles formed of small particles of the phosphor and have a particle diameter in a range of 5 to 10µm.

By the phosphor, including the phosphor particles that are secondary particles formed of small phosphor particles and have a particle diameter in the range of 5 to 10µm, being contained in the phosphor layer, the phosphor is dispersed reliably even when, for example, a resin of practical viscosity is used and thus the luminous efficiency is improved and the color non-uniformity of the emission color is lessened.

"Secondary particles of the phosphor" refers to particles, with which small particles of the phosphor have become bound to each other in a process of sintering a phosphor raw material to prepare the phosphor particles. These secondary particles thus differ from aggregates formed by the gathering together of the small particles of the phosphor. With the phosphor, a portion or all of the small particles of the phosphor have become secondary particles. The ratio of primary particles that have not become secondary particles to the secondary particles is preferably in a range of 1:1 to 0:1, and preferably the particle diameter of the phosphor particles including the primary particles and the secondary particles is in a range of 5 to 10µm. Here, it shall be deemed that the particle diameter of the secondary particles indicates the maximum diameter. Secondary particles, with which the particle diameter as expressed by the maximum diameter is in the range of 5 to 10µm, are thus used. The particle diameter of the secondary particles (in the case where primary particles are present, the particle diameter of the entirety of the phosphor particles including thatoftheprimaryparticles) is obtained by size classification using a sieve, etc., during manufacture of the phosphor. The value of the particle diameter of the phosphor particles is that measured by the Coulter Counter method. Because of being formed by the binding of small particles to each other in a crystal growth process, the secondary particles of the phosphor do not separate readily and exhibit a luminous efficiency close to that of primary particles of a particle diameter corresponding to the maximum diameter. Furthermore, because of being greater in surface area than primary particles of equivalent maximum diameter, the secondary particles have a characteristic of being low in sedimentation rate in a resin or other substance in which the phosphor is dispersed. Thus, even when, for example, a resin having a practical resin viscosity is used, a dispersed type phosphor layer, with which the phosphor particles are dispersed with the lowering of the luminous efficiency of the phosphor being suppressed, can be obtained.

Claim 5 provides a light emitting device including: a light emitting element, disposed on a base member; and a phosphor layer, having a phosphor that emits visible light upon being excited by light emitted from the light emitting element and includes phosphor particles with a particle size distribution in which two or more peaks are present.

Because by using the phosphor that includes the phosphor particles with a particle size distribution in which two or more peaks are present, the state of dispersion of the phosphor particles in the phosphor layer is improved, the luminous efficiency is improved and the color non-uniformity of the emission color is lessened, or reduction of the usage amount of the phosphor is enabled.

"Phosphor particles with a particle size distribution in which two or more peaks are present" refers to phosphor particles with which two or more particle size peaks are found to be present when the particle size distribution of the phosphor particles is measured, for example, by the Coulter Counter method. Such phosphor particles can be obtained by adding, to a phosphor powder that mainly makes up the phosphor in the resin, a phosphor powder of smaller particle diameter.

Claim 6 provides the light emitting device according to claim 4 or 5, in which the phosphor layer is formed by filling and solidifying a resin with a viscosity in a range of 0.1 to 10Pa·s.

By using the resin with a viscosity in the range of 0.1 to 10Pa·s, entrainment of bubbles into the phosphor layer is suppressed.

Claim 7 provides the light emitting device according to any one of the claims 4 to 6, in which the light emitting element includes a light emitting diode element that emits a blue light, and the phosphor includes a yellow to orange light emitting phosphor that emits yellow light or orange light upon being excited by the blue light emitted from the light emitting diode element.

White light is obtained by the blue light, emitted by the light emitting diode element, and the yellow to orange light, emitted by excitation of the yellow to orange light emitting phosphor by the blue light emitted from the light emitting diode element.

Claim 8 provides the illuminating device according to any one of claims 1 to 7, in which a lens disposed on the base member.

Substantially uniform light can be emitted from the light emitting device, and by light distribution control of the emitted light by the lens, the desired light amount can be obtained and light distribution control is enabled.

### EFFECTS OF THE INVENTION

With the light emitting device according to claim 1, because the light from the light emitting element is diffused by the diffusing layer that covers the light emitting element, and the phosphor layer, disposed at the upper layer of the diffusing layer, is excited and made to emit light by the diffused light, the luminous efficiency can be improved and the color non-uniformity of the emission color can be lessened.

With the light emitting device according to claim 2, because, in addition to the effects of the light emitting device according to claim 1, the added amount of the diffusing agent is set to 3 to 5 mass%, the lowering of the luminous efficiency can be suppressed while lessening the color non-uniformity.

With the light emitting device according to claim 3, because, in addition to the effects of the light emitting device according to claim 1 or 2, the surface of bonding of the diffusing layer and the phosphor layer is a concavely curved surface that is recessed toward the light emitting element side, the bonding area can be increased, the strength of bonding of the diffusing layer and the phosphor layer can be fortified, and the peeling of the diffusing layer and the phosphor layer can thus be suppressed in comparison to the case where the bonding surface is a flat surface.

With the light emitting device according to claim 4, because the phosphor, including the phosphor particles that are secondary particles formed of small phosphor particles and have a particle diameter in the range of 5 to 10µm, are contained in the phosphor layer and the phosphor can thus be dispersed reliably even when, for example, a resin of practical viscosity is used, the luminous efficiency can be improved and the color non-uniformity of the emission color can be lessened.

With the light emitting device according to claim 5, because the phosphor, including phosphor particles with a particle size distribution in which two or more peaks are present, is used and the state of dispersion of the phosphor particles in the phosphor layer can thus be improved, the luminous efficiency can be improved and the color non-uniformity of the emission color can be lessened, or the usage amount of the phosphor can be reduced.

With the light emitting device according to claim 6, because, in addition to the effects of the light emitting device according to claims 4 or 5, a resin with a viscosity in the range of 0.1 to 10Pa·s is filled and solidified, entrainment of bubbles can suppressed.

With the light emitting device according to claim 7, in addition to the effects of the light emitting device according to any one of claims 4 to 6, white light can be obtained by the blue light, emitted by the light emitting diode element, and the yellow to orange light, emitted by excitation of the yellow to orange light emitting phosphor by the blue light emitted from the light emitting diode element.

With the illuminating device according to claim 8, because substantially uniform light can be emitted from the light emitting device according to any one of claims 1 to 7 and the emitted light undergoes light distribution control by the lens, the desired light amount can be obtained and light distribution control is enabled.

### BRIEF DESCRIPTION OF THE DRAWINGS

FIG. 1 is an enlarged sectional view of a portion of a light emitting device according to a first embodiment of the present invention;
FIG. 2 is a plan view of the same light emitting device;
FIG. 3 is a sectional view of the same light emitting device;
FIG. 4 is a table showing relationships between the amount of diffusing agent added and light flux in the same light emitting device;
FIG. 5 is an explanatory diagram of a secondary particle of a phosphor used in a light emitting device according to a second embodiment of the present invention;
FIG. 6 is a diagram of a representative particle size distribution of a phosphor having two or more particle size peaks in the same light emitting device;
FIG. 7 is a sectional view of the same light emitting device;
FIG. 8 is a sectional view of an example of an electrode connection structure of a light emitting element of the same light emitting device;
FIG. 9 is a sectional view of another example of the electrode connection structure of the light emitting element of the same light emitting device;
FIGS. 10A to 10D are sectional views of evaluation standards of a state of dispersion of a phosphor in the same light emitting device;
FIG. 11 is a table of evaluation standards for Examples and Comparative Examples of the same light emitting device;
FIG. 12 is a table showing relationships of composition ratios and luminous efficiencies of Examples, each with two particle size peaks, and Comparative Examples, each with one particle size peak, of the same light emitting device;
FIG. 13 is a sectional view of a light emitting module of an illuminating device according to a third embodiment of the present invention;
FIG. 14 is a front view of the same light emitting module;
FIG. 15 is a front view of the same illuminating device; and
FIG. 16 is an explanatory diagram of examples of combinations of materials of the same light emitting module.

### DESCRIPTION OF THE REFERENCE NUMERALS

- 11: light emitting device
- 12: base member
- 18: light emitting diode element as a light emitting element
- 22: diffusing layer
- 23: phosphor layer
- 24: bonding surface
- 31: light emitting device
- 32: base member
- 37: light emitting diode element as a light emitting element
- 41: phosphor
- 42: phosphor layer
- 51: illuminating device
- 61: light emitting diode element as a light emitting element
- 74: diffusing layer
- 75: visible light converting layer as a phosphor layer
- 76: lens

### BEST MODES FOR CARRYING OUT THE INVENTION

Embodiments of the present invention shall now be described with reference to the drawings.

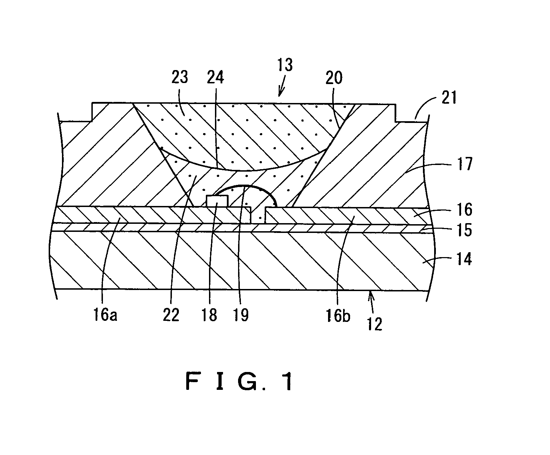

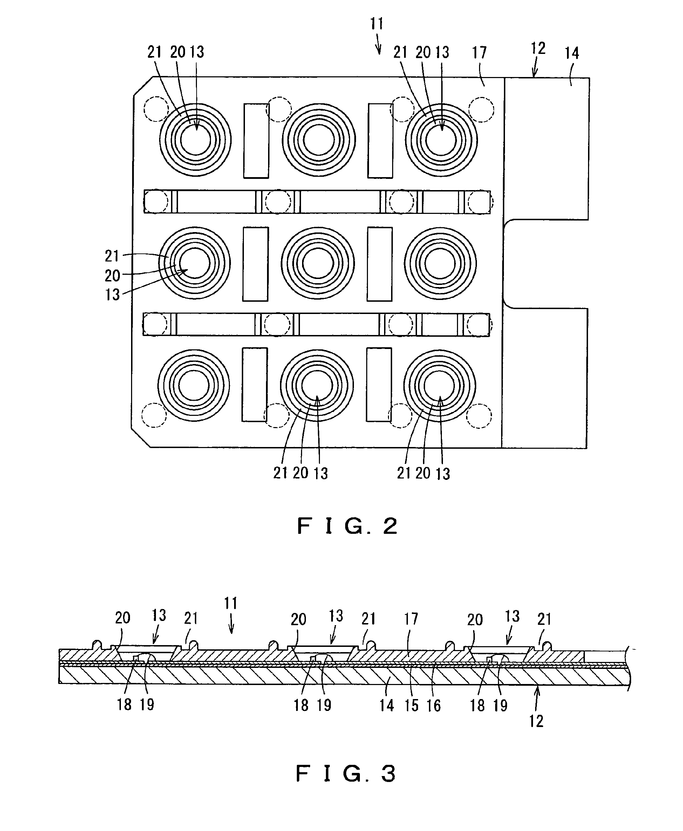

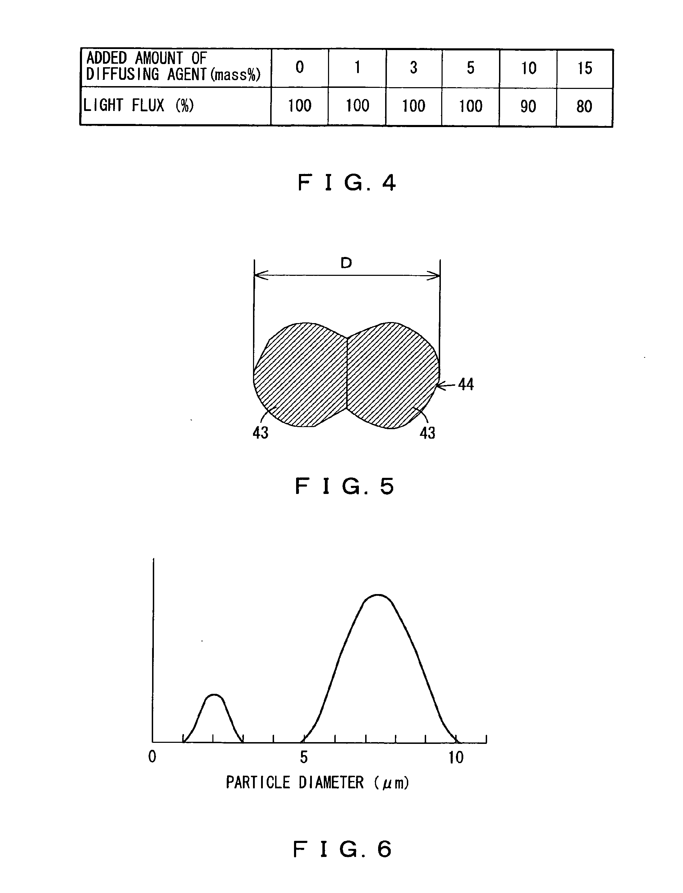

FIG. 1 to FIG. 4 show a first embodiment of the present invention. FIG. 1 is an enlarged sectional view of a light emitting device, FIG. 2 is a plan view of the light emitting device, FIG. 3 is a sectional view of the light emitting device, and FIG. 4 is a table showing relationships between the amount of diffusing agent added and light flux in the light emitting device.

As shown in FIG. 2 and FIG. 3, the light emitting device 11 has a base member 12, and on this base member 12, a plurality of light emitting element positioning portions 13 are formed, for example, in a matrix form of three rows and three columns.

The base member 12 has a planar substrate 14, formed of aluminum (Al), nickel (Ni), a glass epoxy resin, or other material with a heat radiation property and rigidity, an insulating layer 15, formed on the substrate 14, a lead frame 16, formed on the insulating layer 15, and a reflector 17, formed on the substrate 14 on which the insulating layer 15 and the lead frame 16 have been formed.

As shown in FIG. 1, on the lead frame 16, cathode and anode circuit patterns (wiring patterns) 16a and 16b are formed from an alloy of Cu and Ni or of Au, etc., for each light emitting element positioning portion 13. On this lead frame 16, a light emitting diode element (blue light emitting diode chip) 18, which is a solid-state light emitting element that serves as a light emitting element and the emission color of which is blue, is disposed at each light emitting element positioning portion 13. Each light emitting diode element 18 is arranged, for example, from a gallium nitride (GaN) based semiconductor, etc., that emits blue light. With each light emitting diode element 18, a bottom surface electrode thereof is electrically and mechanically connected by die bonding to one of the circuit patterns 16a and 16b and an upper surface electrode is electrically connected by a bonding wire 19 to the other of the circuit patterns 16a and 16b.

The reflector 17 is molded by making a resin, such as PBT (polybutylene terephthalate), PPA (polyphthalamide), or PC (polycarbonate), flow onto one surface of the substrate 14, and has housing portions 20, which house the respective light emitting diode elements 18, formed respectively at the light emitting element positioning portions 13. Each housing portion 20 is formed to a truncated conical shape that gradually spreads towards the opposite side with respect to the substrate 14. A lens holder portion 21 for fixing an unillustrated lens is formed concentrically at a periphery of each housing portion 20.

In each housing portion 20 are formed the two layers of a diffusing layer 22 that covers the light emitting diode element 18 and a phosphor layer 23 that is a layer above the diffusing layer 22 and is disposed at the opening side of the housing portion 20.

The diffusing layer 11 has 3 to 5 mass% of aluminum (Al₂O₃) or Ti, Ca, SiAl, or Y or other diffusing agent added to a thermosetting resin with light transmitting properties, such as a silicone resin, an epoxy resin, etc., and is formed by filling the interior of the housing portion 20 with the resin, containing the diffusing agent, to a position higher than the light emitting diode element 18 and then thermosetting the resin. In this process, a bonding surface (boundary surface) 24 with the phosphor layer 23 is formed to a curved surface that is recessed toward the light emitting diode element 18 side (the lower side in FIG. 3). For example, the bonding surface 24 is preferably such that the interval between the upper end of the curve and the lower end of the curve is 1µm to 5µm.

The phosphor layer 23 has a predetermined mass% of a yellow phosphor, which emits a yellow fluorescence upon receiving the blue emitted light from the light emitting diode element 18, added to a thermosetting resin with light transmitting properties, such as a silicone resin, an epoxy resin, etc., and is formed, after thermosetting and forming of the diffusing layer 22, by filling the interior of the housing portion 20 with the resin to which the phosphor has been added and then thermosetting the resin.

An illuminating device can be arranged by combining the light emitting device 11 and a lens.

Actions of the light emitting device 11 shall now be described.
First, when a predetermined DC voltage is applied from the exterior across the respective cathode and anode circuit patterns 16a and 16b, the respective light emitting diode elements 18 emit blue light. This blue emitted light is diffused in various directions by the diffusing layer 22 and then made to enter the phosphor layer 23, where the blue emitted light excites the yellow phosphor from various directions and makes the phosphor emit yellow light. The blue light from the light emitting diode elements 18 and the yellow light from the yellow phosphor become mixed and become white light, which is emitted to the exterior from the housing portions 20.

Thus, with this light emitting device 11, because the minute light emitted from each light emitting diode element 18 is diffused in various directions by the diffusing layer 22 and excites the yellow phosphor in the phosphor layer 23 from various directions to make the phosphor emit yellow light and the yellow light and the blue light are mixed to emit white light, the color non-uniformity of the white light can be lessened.

Also, because the added amount of the diffusing agent that is added to the resin of the diffusing layer 22 is 3 to 5 mass%, the color non-uniformity of the white light can be lessened without lowering the light flux. The variation of light flux according to the added amount of the diffusing agent is shown in the table of FIG. 4. In this table of FIG. 4, the light flux when the added amount is 0, that is, when no diffusing agent is added is set to 100%.

As shown by the table of FIG. 4, when the added amount of the diffusing agent exceeds 5 mass%, the light flux decreases, while when the added amount falls below 3 mass%, the color non-uniformity lessening effect is lowered.

Data of an experiment of the color non-uniformity lessening effect that was conducted on Samples No. 1 to No. 5 of the light emitting device 11 shall now be described. In this experiment, a yellow phosphor with an emission wavelength of 545nm was used, Al₂O₃, made by Nippon Aerosil Co., Ltd. was used as the diffusing agent, and Tau Silicone JCR6140, made by Toray Industries, Inc., was used as the resin.

### (Experimental Method)

**Sample No. 1: Phosphor only**

| Phosphor layer | | |
|---|---|---|
| | Resin (JCR6140) | 89 mass% |
| | Yellow phosphor | 10 mass% |
| | Red phosphor | 1 mass% |

**Sample No. 2: Two-layer structure of diffusing layer (5 mass%) + phosphor layer**

| Diffusing layer | | |
|---|---|---|
| | Resin (JCR6140) | 95 mass% |
| | Diffusing agent (Al₂O₃) | 5 mass% |

| Phosphor layer | | |
|---|---|---|
| | Resin (JCR6140) | 78 mass% |
| | Yellow phosphor | 20 mass% |
| | Red phosphor | 2 mass% |

**Sample No. 3: Two-layer structure of diffusing layer (10 mass%) + phosphor layer**

| Diffusing layer | | |
|---|---|---|
| | Resin (JCR6140) | 90 mass% |
| | Diffusing agent (Al₂O₃) | 10 mass% |

| Phosphor layer | | |
|---|---|---|
| | Resin (JCR6140) | 78 mass% |
| | Yellow phosphor | 20 mass% |
| | Red phosphor | 2 mass% |

**Sample No. 4 : Two-layer structure of diffusing layer (15 mass%) + phosphor layer**

| Diffusing layer | | |
|---|---|---|
| | Resin (JCR6140) | 85 mass% |
| | Diffusing agent (Al₂O₃) | 15 mass% |

| Phosphor layer | | |
|---|---|---|
| | Resin (JCR6140) | 78 mass% |
| | Yellow phosphor | 20 mass% |
| | Red phosphor | 2 mass% |

**Sample No. 5: Phosphor with diffusing agent mixed**

| | |
|---|---|
| Resin (JCR6140) | 80 mass% |
| Diffusing agent (Al₂O₃) | 20 mass% |
| Resin (JCR6140) | 78 mass% |
| Yellow phosphor | 20 mass% |
| Red phosphor | 2 mass% |

### (Experimental Results)

With the single-layer structure of Sample No. 1, having just the phosphor layer 23 and with the diffusing layer 22 omitted, and with the single-layer structure of Sample No. 5, with which the diffusing layer 22 was likewise omitted and the diffusing agent was added to the phosphor layer 23, the white light emitted to the exterior of the housing portion 20 had yellow light distributed at peripheral portions and a color non-uniformity lessening effect was not provided.

With Samples No. 3 and No. 4, having the two-layer structure of the phosphor layer 23 and the diffusing layer 22 with the added amount of the diffusing agent being 10 mass% and 15 mass%, respectively, because the added amount of the diffusing agent was high, the viscosity of the diffusing layer 22 was high and the diffusing layer 22 was coated non-uniformly. The white light emitted to the exterior of the housing portion 20 thus had yellow light distributed at peripheral portions and a color non-uniformity lessening effect was not provided.

With the two-layer structure of Sample No. 2, having the diffusing layer 22 with the added amount of the diffusing agent being 5 mass% and having the phosphor layer 23 with the added amount of the phosphor being 20 mass%, distribution of yellow light was hardly seen at the peripheral portions of the white light emitted to the exterior of the housing portion 20, and a color non-uniformity lessening effect was thus provided.

When the added proportion of the diffusing agent in the diffusing layer 22 is made greater than 5 mass%, because the light amount of the emitted light of the light emitting diode element 18 that is absorbed by the substrate 14, made, for example, of Ni, increases, the light flux of the white light that is emitted to the exterior from the housing portion 20 decreases.

A white coating or other reflecting material may thus be coated onto a light receiving surface of the substrate 14 to form a reflecting surface to prevent or suppress the lowering of the light flux.

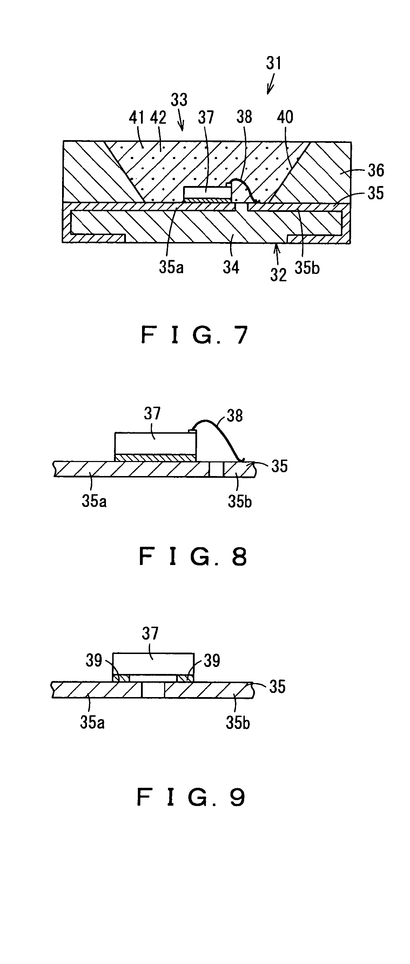

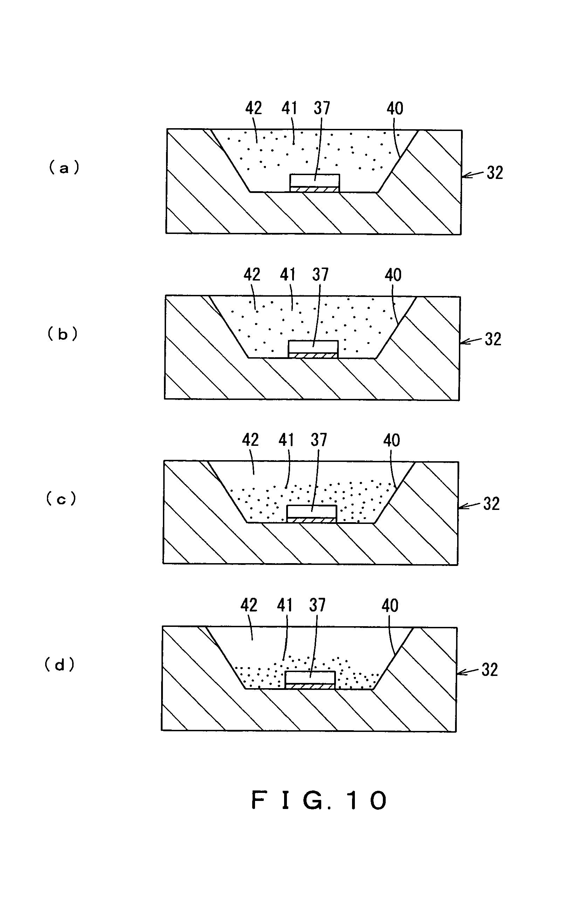

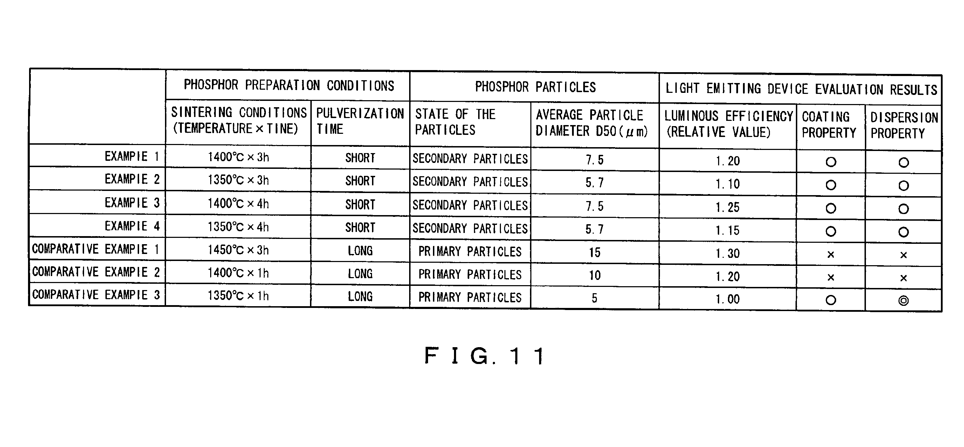

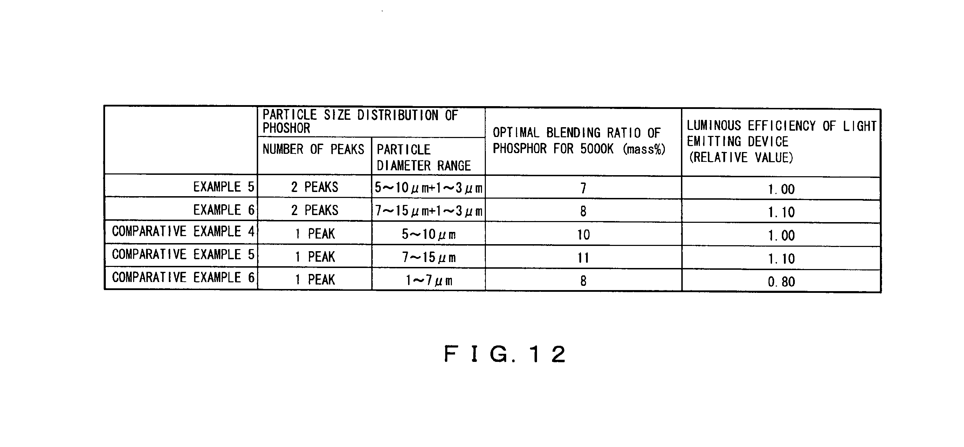

FIG. 5 to FIG. 12 show a second embodiment of the present invention. FIG. 5 is an explanatory diagram of a secondary particle of a phosphor used in a light emitting device, FIG. 6 is a diagram of a representative particle size distribution of a phosphor with two or more particle size peaks, FIG. 7 is a sectional view of the light emitting device, FIG. 8 is a sectional view of an example of an electrode connection structure of a light emitting element of the light emitting device, FIG. 9 is a sectional view of another example of the electrode connection structure of the light emitting element of the light emitting device, FIGS. 10(a) to 10(d) are sectional views of evaluation results of a state of dispersion of a phosphor in the light emitting device, FIG. 11 is a table of evaluation results of Examples and Comparative Examples of the light emitting device, and FIG. 12 is a table showing relationships of composition ratios and luminous efficiencies of Examples, each with two particle size peaks, and Comparative Examples, each with one particle size peak, of the light emitting device.

As shown in FIG. 7, the light emitting device 31 has a base member 32, and a light emitting element positioning portion 33 is formed on this base member 32.

The base member 32 has a substrate 34, a lead terminal 35, formed on the substrate 34, and a reflector 36, formed on the substrate 34 on which the lead terminal 35 has been formed.

On the lead terminal 35, formed on the substrate 34, are formed cathode and anode circuit patterns (wiring patterns) 35a and 35b at the light emitting element positioning portion 33. On this lead terminal 35 is disposed a light emitting diode element (blue light emitting diode chip) 37, which is a solid-state light emitting element that serves as a light emitting element.

As the light emitting diode element 37, for example, a blue emission type light emitting diode chip or an ultraviolet emission type light emitting diode chip is used. A chip connection, such as that shown in FIG. 8, or a flip-chip connection, such as that shown in FIG. 9, is preferably employed as an electrode connection structure of the light emitting diode element 37. By these electrode connection structures, the efficiency of extraction of light to a front face of the light emitting diode element 37 is improved.

With the chip connection shown in FIG. 8, a rear surface electrode of the light emitting diode element 37 is flip-chip connected to the circuit pattern 35a, and an upper surface electrode of the light emitting diode element 37 is electrically connected to the circuit pattern 35b via a bonding wire 38. With the flip-chip connection shown in FIG. 9, solder bumps, Au bumps, Au-Su eutectic bumps, or other bump electrodes 39, disposed on the rear surface of the light emitting diode element 37, are flip-chip connected to the circuit patterns 35a and 35b. FIG. 7 shows the light emitting diode element 37 to which the chip connection, shown in FIG. 8, is applied.

In the reflector 36 at the light emitting positioning portion 33 is formed a housing portion 40 that houses the light emitting diode element 37. The housing portion 40 is formed to a truncated conical shape that gradually spreads towards the opposite side with respect to the substrate 34.

The housing portion 40, in which the light emitting diode element 37 is disposed, is filled with a phosphor layer 42 that is a transparent resin layer containing a phosphor 41, and the light emitting diode element 37 is covered by the phosphor layer 42. The phosphor layer 42 is formed, for example, of a silicone resin or an epoxy resin. The electrical energy applied to the light emitting diode element 37 is converted to blue light or ultraviolet light by the light emitting diode element 37, and this light is converted into light of a longer wavelength by the phosphor 41 contained in the phosphor layer 42. Light of a color that is based on the color of the light emitted from the light emitting diode element 37 and the emission color of the phosphor 41, for example, light of a white color is emitted from the light emitting device 31.

The phosphor layer 42, containing the phosphor 41, is formed by adding and mixing the phosphor 41 into a liquid transparent resin, such as a silicone resin or epoxy resin, and filling the interior of the housing portion 40 with this liquid transparent resin using a dispenser, etc. In terms of restraining the entrainment of air bubbles, etc., inthisprocess, it is preferable to use a liquid transparent resin with a resin viscosity in a range of 0.1 to 10Pa·s. When the resin viscosity of the liquid transparent resin exceeds 10Pa·s, air bubbles, etc., tend to arise readily, and when the resin viscosity is less than 0.1Pa·s, it becomes difficult to form a dispersed type phosphor layer 42 even when secondary particles of the phosphor 41 is used.

The phosphor 41 contained in the phosphor layer 42 emits visible light upon being excited by the light, for example, the blue light or the ultraviolet rays emitted from the light emitting diode element 37. The phosphor layer 42 functions as a light emitting portion and is disposed at the front side in the light emitting direction of the light emitting diode element 37. The type of the phosphor 41 is selected suitably according to the intended emission color of the light emitting device 31 and is not restricted in particular.

For example, to obtain a white emitted light using the light emitting diode element 37 of a blue light emitting type, a yellow to orange light emitting phosphor is mainly used. To improve color rendering properties, etc., a red light emitting phosphor may be used in addition to the yellow to orange light emitting phosphor. As the yellow to orange light emitting phosphor, a YAG phosphor, such as an RE₃ (Al, Ga)₅O₁₂: Ca phosphor (where RE indicates at least one type of element selected from among Y, Gd, and La; the same applies hereinafter), or a silicate phosphor, such as an AE₂SiO₄:Eu phosphor (where AE is an alkaline earth element, such as Sr, Ba, Ca, etc.; the same applies hereinafter), is used.

To obtain white emitted light using the light emitting diode element 37 of an ultraviolet light emitting type, RGB phosphors are used. As a blue light emitting phosphor, for example, a halophosphate phosphor, such as an AE₃(PO₄)₆Cl₁₂:Eu phosphor, or an aluminate phosphor, such as a (Ba, Mg)Al₁₀O₁₇:Eu phosphor is used. As a green light emitting phosphor, an aluminate phosphor, such as a (Ba, Mg)Al₁₀O₁₇:Eu, Mn phosphor is used. As a red light emitting phosphor, an oxysulfide phosphor, such as an La₂O₂S:Eu phosphor is used.

Furthermore, in place of any one of the abovementioned phosphors, a nitride-based phosphor (such as AE₂:Si₅:N₈:Eu), an oxynitride-based phosphor (such as Y₂SiO₃N₄:Ce), a SiAlON-based phosphor (such as AEx (Si, Al)₁₂(N,O)₁₆:Eu), etc. , by which various emission colors can be obtained according to composition, may be applied. The light emitting device 31 is not restricted to a white light emitting lamp, and a light emitting device 31 of an emission color besides white can be arranged as well. To obtain emitted light besides that of white color by means of the light emitting device 31, for example, to obtain emitted light of an intermediate color, various phosphors are used as suited according to the intended emission color.

The phosphor 41 contained in the phosphor layer 42 includes phosphor particles, with which small particles 43 have become bound to each other and have become secondary particles as shown, for example, in FIG. 5, that is, the phosphor 41 includes phosphor secondary particles 44. Furthermore, the particle diameter of the phosphor secondary particles 44 falls within a range of 5 to 10µm. When RGB phosphors are to be used as the phosphors 41, phosphors 41 that include phosphor secondary particles 44 of a particle diameter in the range of 5 to 10µm are used as the respective phosphors for blue, green, and red. The same applies to cases of using a mixture of two or more phosphors 41 besides RGB phosphors.

The phosphor secondary particles 44, such as that shown in FIG. 5, are prepared, for example, as follows. That is, by adjusting a sintering temperature and a sintering time and controlling the crystal growth state of phosphor particles in a process of sintering a phosphor raw material to prepare the phosphor particles, phosphor particles that include the phosphor secondary particles 44 can be obtained. The particle diameter of the phosphor secondary particles 44 can be controlled by applying sieving or other classification process in the manufacturing process.

Because of being formed by the binding of the small particles 43 of the phosphor to each other in the crystal growth process, the phosphor secondary particles 44 do not separate readily and exhibit a luminous efficiency close to that of primary particles having a particle diameter equivalent to the particle diameter D of the secondary particles 44. Furthermore, due to being larger in surface area in comparison to primary particles with a particle diameter equivalent to the particle diameter D, the phosphor secondary particles 44 have a characteristic of being low in sedimentation rate in a liquid transparent resin. The sedimentation of the phosphor 41 in a liquid transparent resin with a resin viscosity in a range, for example, of 0.1 to 10Pa·s can thus be suppressed without lowering the luminous efficiency of the phosphor 41 itself. Here, if the particle diameter of the phosphor secondary particles 44 is less than 5µm, lowering of the luminous efficiency of the phosphor 41 itself cannot be avoided. Meanwhile, if the particle diameter exceeds 10µm, even the phosphor secondary particles 44 tend to sediment readily in the liquid transparent resin.

As described above, by using the phosphor 41 having the phosphor secondary particles 44 of 5 to 10µm particle diameter, the phosphor layer 42 of the phosphor particle dispersed type can be obtained with good reproducibility and with the lowering of the luminous efficiency of the phosphor 41 being suppressed even when a liquid transparent resin with a resin viscosity in the range of 0.1 to 10Pa·s is used. A light emitting device 31 of excellent luminous efficiency can thus be provided. Because in the process of manufacturing the phosphor layer 42, the sedimentation of the phosphor particles in, for example, a dispenser is restrained, the dispersed type phosphor layer 42 can be prepared efficiently and yet with high precision. Improvement of the manufacturing yield and reduction of the manufacturing cost of the light emitting device 31 are thus enabled.

For example, in a case of using the light emitting diode element 37 of the blue emission type, a white emission is obtained by the mixing of the blue light, resulting from the blue emission of the light emitting diode element 37 and passing in between the particles of the phosphor 41, and the yellow to orange light, emitted by excitation of the phosphor 41 by the blue emission. The particle size and shape of the phosphor 41 thus greatly influence the emission color of the light emitting device 11. When the particle size of the phosphor 41 is large, because gaps become large, a desired color temperature cannot be obtained unless the blending ratio of the phosphor 41 is increased. Meanwhile, when the phosphor 41 that includes the phosphor secondary particles 44 is used, because the gaps among the phosphor 41 decreases, the amount of phosphor necessary to obtain the intended white color temperature can be reduced. The manufacturing cost of the light emitting device 31 can thus be reduced.

An example of the light emitting device 31 that uses a phosphor, having phosphor particles with two or more particle size peaks, in place of the secondary particles 44 shall now be described. The basic arrangement of the light emitting device 31 is the same as that described above.

The phosphor 41 contained in the phosphor layer 42 includes phosphor particles, with which two or more peaks are present in a particle size distribution. Specifically, the phosphor 41 includes a first phosphor particle group that mainly makes up the phosphor 41 in the phosphor layer 42 and a second phosphor particle group of smaller average particle diameter as shown in FIG. 6. Preferably in terms of maintaining the luminous efficiency of the light emitting device 31, the average particle diameter of the first phosphor particle group is in a range, for example, of 5 to 15µm. Meanwhile, the particles of second phosphor particle group improve the dispersed state of the phosphor 41 in the phosphor layer 42 by being present between particles of the first phosphor particle group and thus preferably have an average diameter in a range, for example, of 1 to 3µm.

By thus making the second phosphor particle group be present between particles of the first phosphor particle group, improvement of the emission color and the luminous efficiency of the light emitting device 31 or reduction of the usage amount of the phosphor 41 can be achieved. For example, in a case of obtaining white emission using the light emitting diode 37 of the blue emission type, by making the second phosphor particle group be present between particles of the first phosphor particle group, the emission amount of the yellow to orange light emitting phosphor is improved. The amount of phosphor necessary to obtain the intended white color temperature can thus be reduced. Also, in the case where the phosphor amount is the same, the white color temperature and the emission luminance can be improved.

An illuminating device can be arranged by combining the light emitting device 31 with a lens.

Examples of the second embodiment and evaluation results thereof shall now be described with reference to the tables of FIG. 11 and FIG. 12.

First, Examples 1 to 4 and Comparative Examples 1 to 3 shall be described.

YAG phosphors, each of a composition, (Y, Gd)₃(Al, Ga)₅O₂:Ce, were respectively prepared as follows. That is, predetermined amounts of the respective elements (Y, Gd, Ga, and Ce) were weighed, dissolved, and then coprecipitated. After then mixing the coprecipitate with ammonium chloride, as a flux, and alumina, sintering in air was carried out under conditions shown in the table of FIG. 11. The sintered product was then pulverized and thereafter subject to the respective processes of washing, separation, and drying and then classified using sieves to obtain the intended YAG phosphor. The average particle diameter of the YAG phosphor was adjusted by the sieve openings of the sieves. For example, with the Example 1, particles less than 5µm and particles exceeding 10µm were eliminated by sieves.

By using a SEM to observe the particle shapes of the respective YAG phosphors thus obtained, it was confirmed that the YAG phosphors of all of the Examples 1 to 4 included secondary particles. Although the respective YAG phosphors contained primary particles as portions thereof, the proportion of the primary particles was approximately 20% in all cases. The ratio (number ratio) of the primary particles to the secondary particles was thus 2:8. On the other hand, the YAG phosphors of all of the Comparative Examples 1 to 3 remained in the form of primary particles. The average diameters of the respective YAG phosphors were measured by the Coulter Counter method. The results are shown in the table of FIG. 11.

Light emitting devices of the arrangement shown in FIG. 7 were then manufactured using the respective YAG phosphors. That is, the respective YAG phosphors were dispersed in silicone resins with a resin viscosity of 0.3Pa·s. Each light emitting device was prepared by filling each of the silicone resins into the interior of a housing portion using a dispenser and thereafter hardening the silicone resin. The amount of YAG phosphor added with respect to the silicone resin was set to 10 mass%. For each of the light emitting devices 31 thus prepared, the luminous efficiency of the phosphor, the coating property of the silicone resin containing the phosphor, and the dispersion property of the phosphor in the silicone resin layer were examined. The measurement results are shown in the table of FIG. 11.

The luminous efficiency of the phosphor is a relative value, with that of the Comparative Example 3 being set to 1. In regard to the coating property of the silicone resin containing the phosphor, cases where there was no sedimentation of the phosphor in the dispenser and the fluctuation of the coating amount under the same coating conditions (coating pressure, time) was small were evaluated as ○, and cases where the phosphor sedimented inside the dispenser and the fluctuation of the coating amount under the same coating conditions was large were evaluated as ×. In regard to the dispersion property of the phosphor in the silicone resin layer, cases where the phosphor 41 was dispersed uniformly above the light emitting diode 37 as shown in FIG. 10(a) were evaluated as ⓪, cases where the phosphor 41 was dispersed over the entirety of the phosphor layer 42 as shown in FIG. 10 (b) were evaluated as ○, cases where the phosphor 41 was dispersed in a range of no more than half of the phosphor layer 42 as shown in FIG. 10 (c) were evaluated as Δ, and cases where the phosphor 41 sedimented at a lower portion of the phosphor layer 42 as shown in FIG. 10(d) were evaluated as X.

As is clear from the table of FIG. 11, with the respective Examples using the phosphor secondary particles, despite using a transparent resin with a resin viscosity of 0.3Pa·s, the coating property of the transparent resin and the dispersion of the phosphor in the resin layer are excellent. These thus enable the realization of a dispersed type structure of the phosphor 41 in a resin layer without entrainment of air bubbles, etc. It can also be understood that by arranging such a dispersed type resin layer, the luminous efficiency is improved. Similar results were also obtained in cases of using a transparent resin with a resin viscosity of 3Pa·s. It was also confirmed that even in cases of using RGB phosphors as other types of phosphor, dispersion type resin layers can be obtained with good reproducibility by use of phosphor secondary particles.

Examples 5 and 6 and Comparative Examples 4 to 6 shall now be described.

A phosphor of the Example 5 was prepared by mixing a YAG phosphor, with which the particle diameter range was adjusted to 5 to 10µm by sieving, and a YAG phosphor, with which the particle diameter range was adjusted to 1 to 3µm by sieving. In likewise manner, a phosphor of the Example 6 was prepared by mixing a YAG phosphor, with which the particle diameter range was adjusted to 7 to 15µm by sieving, and a YAG phosphor, with which the particle diameter range was adjusted to 1 to 3µm by sieving. With the Comparative Examples 4 to 6, a YAG phosphor with which the particle diameter range was 5 to 10µm, a YAG phosphor with which the particle diameter range was 7 to 15µm, and a YAG phosphor with which the particle diameter range was 1 to 7µm were respectively used solitarily.

Using the above-described phosphors of the respective Examples and Comparative Examples, light emitting devices were respectively prepared in the same manner as the Example 1. In this process, the weights of phosphor (blending amount of phosphor with respect to the silicone resin) with which a white color temperature of 5000K can be obtained were examined. Furthermore, the luminous efficiencies of the light emitting devices with a white color temperature of 5000K were measured. These measurement results are shown in the table of FIG. 12. The luminous efficiency of the phosphor is a relative value with that of the Comparative Example 4 being set to 1.

As is clear from the table of FIG. 12, with the light emitting device of the Examples 5 and 6, the blending amount of the phosphor for obtaining the same color temperature can be reduced without lowering the luminous efficiency of the phosphor. The manufacturing cost can thus be lowered without lowering the characteristics of the light emitting device.

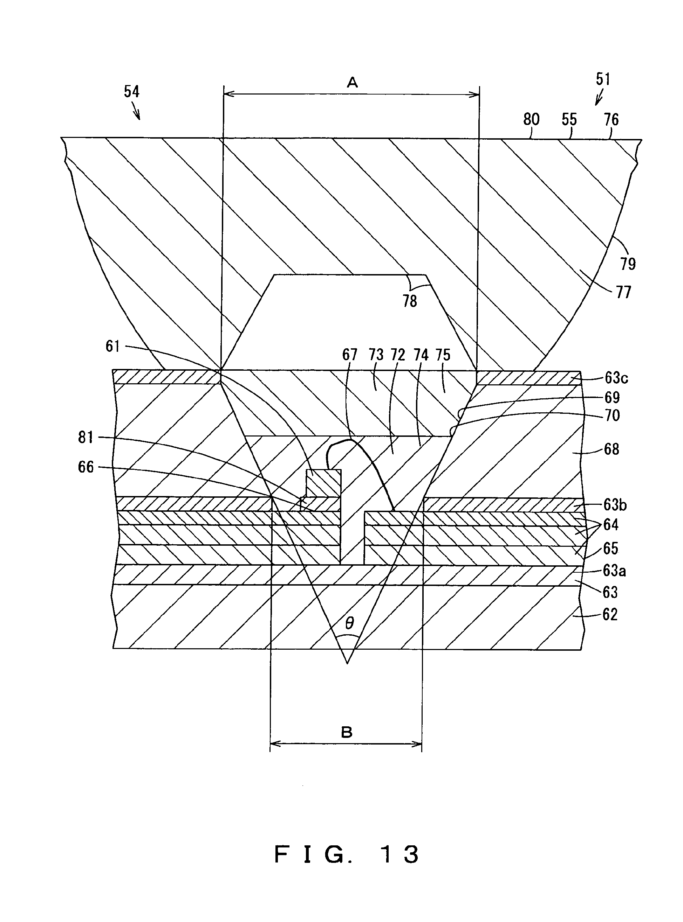

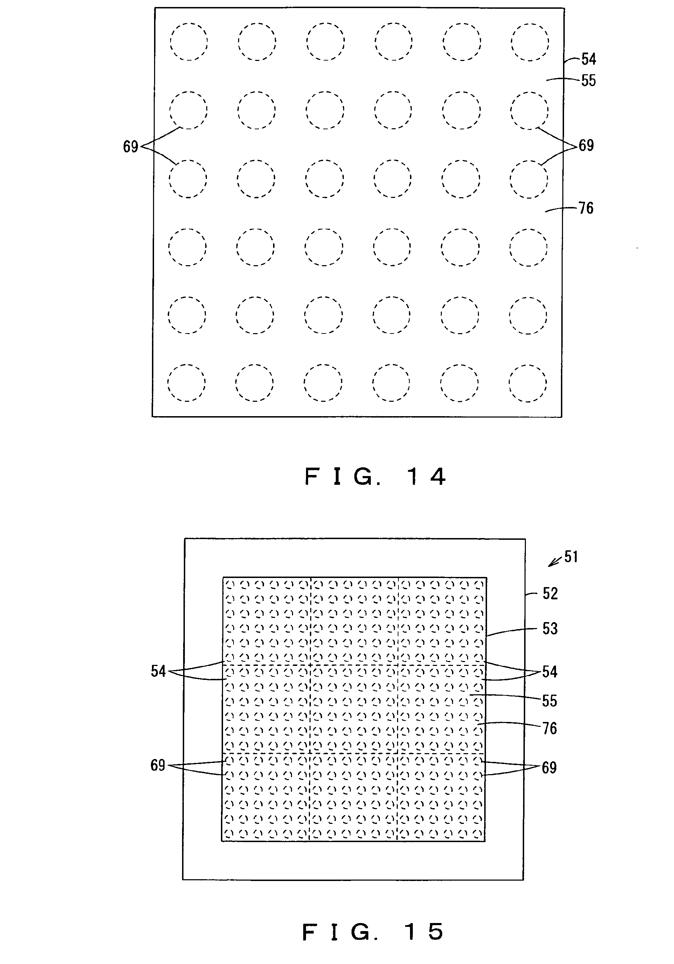

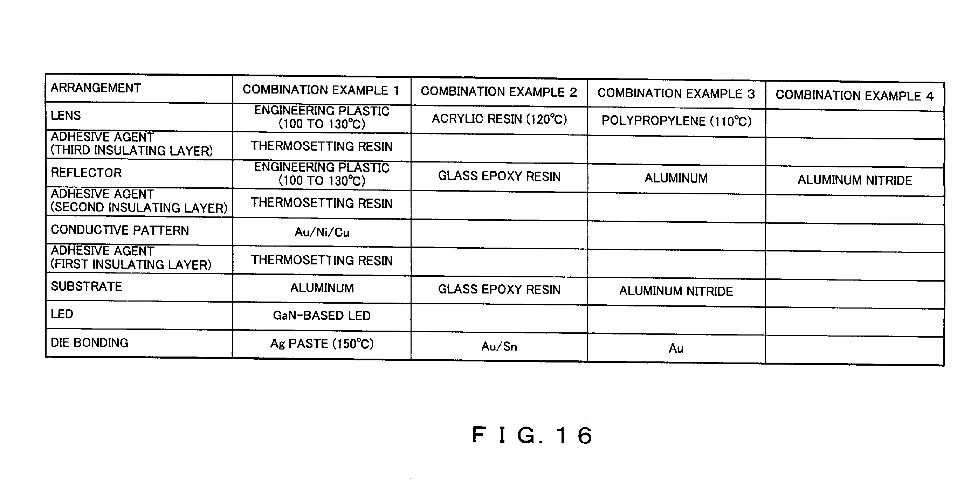

FIG. 13 to FIG. 16 show a third embodiment. FIG. 13 is a sectional view of a light emitting module of an illuminating device, FIG. 14 is a front view of the light emitting module, FIG. 15 is a front view of the illuminating device, and FIG. 16 is an explanatory diagram of examples of combinations of materials of the light emitting module.

In FIG. 15, 51 is the illuminating device, and this illuminating device 51 has a thinly-formed, rectangular main device body 52, a rectangular opening 53 is formed on a surface of this main device body 52, a plurality of rectangular light emitting modules 54 are arrayed in matrix form inside the opening 53, and a light emitting surface 55 is formed by the plurality of light emitting modules 54.

As shown in FIG. 13, each light emitting module 54 has, as light emitting elements, light emitting diode elements (light emitting diode chips) 61, which are solid-state light emitting elements, and the plurality of light emitting diode elements 61 are disposed in matrix form on one surface side, that is, the top surface side of a substrate 62, formed, for example, of a glass epoxy resin, aluminum, aluminum nitride, or other material of high heat conductance.

On the one surface of substrate 62, an adhesive agent 63 is coated as an insulating layer that is a thermosetting resin or a thermoplastic resin having an elastic modulus lower than epoxy resins and higher than engineering plastics and having an insulating property and a heat conducting property, and an electrically conductive layer 64 of, for example, copper, gold, or nickel, etc., is adhered and positioned via the first insulating layer 63a formed from the adhesive agent 63. A circuit pattern 65 is formed by the electrically conductive layer 64, and light emitting element positioning portions 66, onto which the light emitting diode elements 61 are mounted, are formed in matrix form on the circuit pattern 65. At each light emitting element positioning portion 66, one electrode of each light emitting diode element 61 is connected by die bonding by a silver paste that serves as a connecting layer 81 onto one of the pole patterns of the circuit pattern 65, and the other electrode is connected by wire bonding by a wire 67 to the other pole pattern of the circuit pattern 65.

On the one surface side of the substrate 62, a reflector 68, formed of a glass epoxy resin, an engineering plastic, aluminum, aluminum nitride, or other material having high heat resistance and highly reflecting characteristics, is adhered and positioned via a second insulating layer 63b, formed of the adhesive agent 63 of a same type as that of the first insulating layer 63a. In correspondence to the respective light emitting element positioning portions 66, a plurality of housing portions 69, in which the light emitting diode elements 61 are respectively positioned in a housed state, are openingly formed in the reflector 68. With each housing portion 69, an aperture diameter A, at a lens 76 side, that is, a top surface side at the side opposite the substrate 62 side, is greater than an aperture diameter B at the substrate 62 side, that is, a rear surface side, and each housing portion 69 thus spreads open from the substrate 62 side to a lens 76 side, that is, from the rear surface side to the top surface side and has formed thereon a reflecting surface 70 that is inclined so as to face the interior of the housing portion 69. As the reflecting surface 70, a reflecting film of white titanium oxide, copper, nickel, aluminum, or other material of high reflectance may be formed.

The shape of each housing portion 69 satisfies a relationship, θ = tan⁻¹{h/(A-B) }>45°, where A is the aperture diameter at the lens 76 side that is opposite the substrate 62 side, B is the aperture diameter at the substrate 62 side, h is a depth of the housing portion 69, and θ is an angle of spread of the housing portion 69 from the substrate 62 side to the lens 76 side.

In each housing portion 69, two transparent resin layers 72 and 73 are formed so as to cover the light emitting diode element 61. For the lower resin layer 72 that directly covers the light emitting diode 61, for example, a silicone resin that is strong against ultraviolet rays and has elasticity is used, and this layer is a diffusing layer 74 in which is dispersed a diffusing agent that diffuses visible light and ultraviolet rays from the light emitting diode element 61. A silicone resin, an epoxy resin, a modified epoxy resin layer, etc., is used as the upper resin layer 73, which is arranged as a visible light converting layer 75 that is a phosphor layer having a visible light converting substance, such as a phosphor that converts the ultraviolet rays from the light emitting diode element 61 into visible light, sedimented therein.

At the top surface side of the reflector 68, the lens 76, formed, for example, of polycarbonate, an acrylic resin, or other light transmitting resin, is disposed via a third insulating layer 63c formed of the adhesive agent 63 of the same type as that of the first insulating layer 63a and the second insulating layer 63b. If a thermosetting resin is used in the substrate 62, the same type of thermosetting resin is used in the material of the lens 76. If a thermoplastic resin is used in the substrate 62, the same type of thermoplastic resin is used in the material of the lens 76.

The lens 76 has lens portions 77 that are formed to lens shapes in correspondence to the respective light emitting diode elements 61, and with each lens portion 77, a recessed incidence surface 78, which opposes the housing portion 69 and onto which light is made incident, a reflecting surface 79, which reflects light made incident onto the incidence surface 78, and an exit surface 80, from which the light made incident onto the incidence surface 78 and the light reflected by the reflecting surface 79 exit, are formed. The light emitting surface 55, common to the light emitting modules 54, is formed from the light emitting surfaces 80 of the plurality of lens portions 77.

A base member is formed from the substrate 62, the circuit pattern 65, the reflector 68, etc. By combining this member with the light emitting diode element 61, a light emitting device is formed. By combining this light emitting device with the lens 76, etc., the light emitting module 54 is formed, and the illuminating device 51 is formed from a plurality of the light emitting modules 54.

Also, in FIG. 16 are indicated combination examples 1, 2, 3, and 4 of combinations of the substrate 62, the adhesive agent 63 (the first insulating layer 63a, the second insulating layer 63b, and the third insulating layer 63c), the electrically conductive layer 64, the reflector 68, and the lens 76. For the combination examples 2, 3, and 4, just the combinations of materials that differ from that of the combination example 1 are shown.

During lighting of the light emitting diode elements 61, the heat generated by the light emitting diode elements 61 is transferred to the substrate 62, the electrically conductive layer 64, the reflector 68, the lens 76, etc., and thermal expansion differences arise due to the material differences of the substrate 62, the electrically conductive layer 64, the reflector 68, and the lens 76. Because the substrate 62, the electrically conductive layer 64, the reflector 68, and the lens 76 are adhered and fixed together using the same type of adhesive agent 63, which is a thermosetting resin or a thermoplastic resin having an elastic modulus lower than epoxy resins and higher than engineering plastics, the thermal expansion differences can be absorbed, the occurrence of peeling can be suppressed, and the adhesively fixed state can be maintained reliably.

Also, because the electrically conductive layer 64, the light emitting diode elements 61, the reflector 68, the resin layers 72 and 73, and the lens 76 are disposed on the substrate 62 and the reflector 68 and the lens 76 are respectively adhered using the same type of adhesive agent 63, the radiation of heat from the substrate 62 can be improved, the occurrence of peeling and warping among the substrate 62, the reflector 68, and the lens 76 can be suppressed to enable the optical characteristics to be maintained, and degradation of the resin layers 72 and 73, the lens 76, etc., can be suppressed to enable improvement of the light extraction efficiency. Also, because the same type of adhesive agent 63 is used, the lens 76 can be mounted efficiently during manufacture of the substrate.

Also, because the shape of each housing portion 69 is defined to satisfy the relationship, θ = tan⁻¹{h/(A-B)}>45°, where A is the aperture diameter at the lens 76 side, B is the aperture diameter at the substrate 62 side, h is the depth of the housing portion 69, and θ is the angle of spread from the substrate 62 side to the lens 76 side, the efficiency of light extraction from the housing portion 69 can be optimized and the design of the housing portion 69 can be facilitated regardless of the dimensions and type of the light emitting diode elements 61.

Also, because the upper resin layer 73 among the two resin layers 72 and 73 covering the light emitting diode element 61 disposed in the housing portion 69 is the visible light converting layer 75 in which the visible light converting substance is sedimented, a large amount of light of the visible range can be extracted readily and the light extraction efficiency can be improved. Moreover, because the visible light converting substance is sedimented, the visible light and ultraviolet rays illuminated from the lower resin layer 72 can be illuminated efficiently onto the visible light converting substance, and the thickness of the upper resin layer 73 can be set as suited.

Because the lower resin layer 72 is arranged as the diffusing layer 74 in which the diffusing agent is mixed, the light emitted from the light emitting diode element 61 can be illuminated uniformly onto the boundary surface with the upper visible light converting layer 75.

If the wire 67 is positioned at the boundary surface of the two resin layers 72 and 73, this becomes a cause of color non-uniformity. The height position of the wire 67 is determined by the height of the light emitting diode element 61, the hardness and workability of the wire 67, etc. Thus, if the height of the light emitting diode element 61 is approximately 75µm and the height from the bottom surface of the housing portion 69 to the highest point of the wire 67 is 200µm, preferably the lower resin layer 72 is made 250µm in thickness and the upper resin layer 73 is made 750µm in thickness, and in a case where the height from the bottom surface of the housing portion 69 to the highest point of the wire 67 is 425µm, preferably the lower resin layer 72 is made 475µm in thickness and the upper resin layer 73 is made 525µm in thickness. The depth of the housing portion 69 is thus optimally 800 to 1200µm and is more preferably 1000µm.

Inorganic nanoparticles, which are a filler of no more than 10⁻⁹m, are dispersed in the lower resin layer 72. As the nanoparticles, nanosilica, etc., which is controlled to a narrow viscosity distribution of no more than 50nm, is used, with the weight composition being 0.1% to 60% and the visible light transmittance being 50% to 90%.

By thus dispersing inorganic nanoparticles in the resin layer 72, the conductance of heat to the substrate 62, the reflector 68, the lens 76, etc., is improved and the heat radiation property can be improved.

### INDUSTRIAL APPLICABILITY

The present invention can be used in a fixed illumination arrangement for indoor or outdoor use, a moving body illumination arrangement for a vehicle, etc.

## Claims

1. A light emitting device comprising:
a light emitting element, disposed on a base member;
a diffusing layer, covering the light emitting element; and
a phosphor layer, disposed on top of the diffusing layer.

2. The light emitting device according to Claim 1, wherein the diffusing layer has a diffusing agent, and an added amount of the diffusing agent is 3 to 5 mass%.

3. The light emitting device according to Claim 1 or 2, wherein
a bonding surface of the diffusing layer and the phosphor layer is formed to a concavely curved surface that is recessed toward the light emitting element side.

4. A light emitting device comprising:
a light emitting element, disposed on a base member; and
a phosphor layer, having a phosphor that emits visible light upon being excited by light emitted from the light emitting element and includes phosphor particles, which are secondary particles formed of small particles of the phosphor and have a particle diameter in a range of 5 to 10µm.

5. A light emitting device comprising:
a light emitting element, disposed on a base member; and
a phosphor layer, having a phosphor that emits visible light upon being excited by light emitted from the light emitting element and includes phosphor particles with a particle size distribution in which two or more peaks are present.

6. The light emitting device according to Claim 4 or 5, wherein
the phosphor layer is formed by filling and solidifying a resin with a viscosity in a range of 0.1 to 10Pa·s.

7. The light emitting device according to any one of Claims 4 to 6, wherein
the light emitting element includes a light emitting diode element that emits a blue light, and
the phosphor includes a yellow to orange light emitting phosphor that emits yellow light or orange light upon being excited by the blue light emitted from the light emitting diode element.

8. An illuminating device, comprising:
the light emitting device according to any one of Claims 1 to 7; and
a lens disposed on the base member.
